# EUROPEAN PATENT APPLICATION

(11) **EP 4 199 100 A1**
(43) Date of publication of application: **21.06.2023**
(21) Application number: 21215903.2
(22) Date of filing: 20.12.2021
(51) Int. Cl.: H01L 29/06, H01L 29/08, H01L 29/739

(54) **REVERSE-CONDUCTING INSULATED GATE BIPOLAR TRANSISTOR**

(71) Applicant: Hitachi Energy Switzerland AG, 5400 Baden (CH)
(72) Inventor: BOKSTEEN, Boni Kofi, 5600 Lenzburg (CH); VITALE, Wolfgang Amadeus, 5000 Aarau (CH)
(74) Representative: Epping - Hermann - Fischer

(57) **Abstract**

According to an embodiment, the RC-IGBT (1000) comprises a semiconductor body (100) with an emitter side (101) and a collector side (102), a collector layer (1) at the collector side with at least one pilot region (10) and at least one mixed region (11) and a collector electrode (2) on the collector side and in electrical contact with the collector layer. The pilot, IGTB, region is of a first conductivity type. The mixed region has first subregions (111) that are also of the first conductivity type and second, diode, subregions (112) that are of a second, opposite, conductivity type. The doping concentration in the first subregions is different from the doping concentration in the pilot region.

## Description

The present disclosure relates to a Reverse-Conducting Insulated Gate Bipolar Transistor, in the following also referred to as RC-IGBT. Furthermore, the disclosure relates to a method for producing a Reverse-Conducting Insulated Gate Bipolar Transistor.

There is a need for an improved RC-IGBT, for example with an improved trade-off between robustness, like Safe Operating Area (SOA) capability, and static loss. Furthermore, there is a need for an improved method for producing such an RC-IGBT.

Embodiments of the disclosure relate to an RC-IGBT with an improved trade-off between SOA capability and static loss. SOA is the abbreviation for safe operation area. Further embodiments relate to a method for producing an RC-IGBT.

First, the RC-IGBT is specified.

According to an embodiment, the RC-IGBT comprises a semiconductor body with an emitter side and a collector side, a collector layer at the collector side with at least one pilot region and at least one mixed region and a collector electrode on the collector side and in electrical contact with the collector layer. The pilot region is of a first conductivity type. The mixed region has first subregions of the first conductivity type and second subregions of a second conductivity type. The doping concentration in the first subregions is different from the doping concentration in the pilot region.

By having different doping concentrations for the pilot region and the fist subregions, the robustness can be increased without increasing the static losses. For example, by reducing the doping concentration in the pilot region and/or increasing the doping concentration in the first subregions, the Reverse Bias SOA (RBSOA) can be increased while maintaining or reducing the static losses. A more even current / plasma distribution in the whole active region of the device, particularly during high current turn-off (RBSOA), can be obtained.

The disclosed RC-IGBT combines the advantages of improved robustness (particularly high RBSOA) without, or with limited, increase of conduction losses. The improvements provide the opportunity to expand the range of possibilities for low condition loss devices that are not RBSOA limited. This is particularly advantageous for the low frequency High-Voltage DC (HVDC) systems in which the RC-IGBT is predominantly used. Moreover, the disclosed RC-IGBT does not need major changes in the manufacturing method, but at most an additional photolithography step.

An RC-IGBT having a pilot region, as disclosed herein, is commonly also referred to as Bi-mode Integrated Gate Transistor, BIGT for short. A BIGT constitutes a hybrid structure of an IGBT and a standard RC-IGBT. The IGBT is realized in the area of the pilot region and may therefore also be referred to as pilot-IGBT. The standard RC-IGBT is realized in the area of the mixed region. Both, the IGBT and the standard RC-IGBT are implemented in one single device or one single chip, respectively. The pilot-IGBT is, e.g., sized to reduce the snapback in the forward conduction mode at low temperatures. In the following, if not stated otherwise, the expression "RC-IGBT" refers to the RC-IGBT with the pilot region, hence to the BIGT, and not to the standard RC-IGBT forming part of the BIGT.

The semiconductor body can comprise or consist of silicon. The emitter side and the collector side are, e.g., opposite sides which delimit the semiconductor body in two opposite directions. The distance between the emitter side and the collector side is the thickness of the semiconductor body.

The collector layer may be part of the semiconductor body. The collector layer may be made of semiconductor material, e.g. silicon. For example, the collector layer forms the collector side.

The different regions of the collector side, like the pilot region, the subregions and the below defined edge region may reach to the collector side, i.e. may each form a part or an area of the collector side. The different regions may each extend over the whole thickness of the collector layer.

The collector electrode may adjoin the collector side and may be in electrical contact with the collector layer. The collector electrode may comprise or may consist of a metal.

The pilot region is of the first conductivity type, e.g. exclusively of the first conductivity type. The first conductivity type may be either hole conduction or electron conduction. Accordingly, the pilot region may be either p-doped or n-doped. For example, the pilot region is homogeneously doped across its entire volume and/or across its entire lateral expansion.

Here and in the following, a homogeneous doping concentration means homogeneous within the limits of manufacturing tolerance, e.g. with a maximum deviation from an average doping concentration of at most 5 %.

A lateral direction is herein understood to be a direction parallel to the collector side or to a main extension plane of the collector layer or of the semiconductor body, respectively.

The mixed region comprises first subregions of the first conductivity type, e.g. exclusively of the first conductivity type, and second subregions of a second conductivity type, e.g. exclusively of the second conductivity type. The second conductivity type may accordingly be electron conduction or hole conduction. For example, the first subregions are p-doped and the second subregions are n-doped or vice versa. All the first subregions may have the same doping concentration and/or may be homogeneously doped across their respective entire lateral expansion and/or volume. Likewise, all the second subregions may have the same doping concentration and/or may be homogeneously doped within the manufacturing tolerances across their respective entire lateral expansion and/or volume. For example, the first subregions and the second subregions are arranged in an alternating manner in the mixed region.

Here and in the following, a same doping concentration means the same doping concentration within the limits of manufacturing tolerances, e.g. with a maximum deviation in the maximum or average doping concentration of at most 5%.

The area of the pilot region may be larger than the area of each of the first and/or second subregions, e.g. it may be at least 5 times or at least 10 times or at least 100 times the area of each of the first and/or second subregions. For example, an area of a region or subregion is herein understood to be the area of the respective region/subregion at the collector side.

The pilot region and/or the mixed region may be contiguous regions. For example, the pilot region is a simply-connected region, i.e. a contiguous region without interruptions.

The doping concentration of the pilot region is different from the doping concentration of the first subregions. For example, the doping concentrations differ from each other by a factor of at least 1.1 or at least 1.5 or at least 2 or at least 5 or at least 10. Here and in the following, a comparison between doping concentrations of two regions/subregions may be a comparison between the average doping concentrations and/or maximum doping concentrations of these regions/subregions. The comparison may also concern the doping concentration at a surface of the regions/subregions, e.g. at the collector side. The maximum doping concentration may be at a surface of a region.

For example, the doping concentration in the pilot region is between 1·10¹⁶ cm⁻³ inclusive and 5·10¹⁹ cm⁻³ inclusive, e.g. between 1·10¹⁵ cm⁻³ inclusive and 5·10¹⁸ cm⁻³ inclusive.

According to a further embodiment, the doping concentration in the first subregions is larger than the doping concentration in the pilot region. For example, the doping concentration in each first subregion is at least 1.1 times or at least 1.5 times or at least 2 times or at least 5 times or at least 10 times the doping concentration in the pilot region. The dopants of the pilot region and of the first subregions may be the same, for instance Boron.

Decreasing the doping concentration in the pilot region increases the RBSOA capability and the Short Circuit SOA (SCSOA) (hot) capability, but it may have an undesired effect on the static loss and may increase the on-state loss in the IGBT operating mode. Increasing the doping concentration in the first subregions of the mixed region decreases the on-state loss in the IGBT operating mode, compensating the effect of the decreased doping concentration in the pilot region. In this way it is possible to provide a BIGT device with a similar on-state loss to known devices, but with an improved RBSOA and SCSOA (hot) capability.

According to a further embodiment, the collector layer further comprises an edge region. The edge region may extend to the edge of the collector layer delimiting the collector layer in lateral direction. For example, the edge region forms all edges of the collector layer.

In lateral direction, the edge region may overlap with a termination region of the RC-IGBT. For example, the edge region completely or partially overlaps with the termination region of the RC-IGBT.

According to a further embodiment, the edge region laterally surrounds the pilot region and/or the mixed region. For example, the edge region laterally completely surrounds the pilot region and/or the mixed region. The edge region may form a frame around the pilot region and/or the mixed region. An area of the edge region may be greater than an area of each first and/or second subregions. For example, the edge region has a constant width along its extension around the mixed region and/or the pilot region.

According to a further embodiment, the bigger part (majority) of the edge region is either of the first or the second conductivity type. A bigger part of the edge region may herein mean a bigger part of the area of the collector side formed by the edge region or a bigger part of the volume of the edge region. Bigger part means, e.g., more than 50 % or at least 75 %.

For example, the edge region comprises one subregion, also referred to as third subregion, which is exclusively of the first or the second conductivity type. The third subregion may form the bigger part of the edge region. The third subregion may be a contiguous subregion of the edge region. For example, the third subregion laterally completely surrounds the mixed region and/or the pilot region. The third subregion may be homogenously doped.

According to a further embodiment, the bigger part of the edge region is of the same conductivity type as the first subregions and has the same doping concentration as the first subregions.

According to a further embodiment, the bigger part of the edge region is of the same conductivity type as the first subregions but has a different doping concentration than the first subregions. For example, the bigger part of the edge region has a lower doping concentration than the first subregions. In this way, leakage can be reduced while SCSOA (hot) capability is further improved.

The doping concentration of the edge region may be at most 0.9 times or at most 0.5 times or at most 0.1 times the doping concentration of the first subregions. For instance, the doping concentration of the edge region is the same as in the pilot region. Alternatively, the doping concentration of the edge region may be at least 1.1 times or at least 2 times or at least 10 times the doping concentration of the first subregions.

According to a further embodiment, the bigger part of the edge region is of the same conductivity type as the pilot region and has the same doping concentration as the pilot region.

According to a further embodiment, the bigger part of the edge region is of the same conductivity type as the second subregions. In this case, the bigger part of the edge region may have a different doping concentration than the second subregions or the same doping concentration as the second subregions. For example, the bigger part of the edge region is n-doped. In this way, on-state loss in the diode operating mode can be reduced since the emitter connected portion of the p-type termination region acts as an additional anode area for the BIGTs' internal diode.

The doping concentration in the bigger part of the edge region might be lower than the doping concentration of the second subregions in the mixed region, e.g. at most 0.9 times or at most 0.5 times or at most 0.1 times the doping concentration of the second subregions. Additionally or alternatively, the doping concentration in the bigger part of the edge region may be at least 1.1 times or at least 2 times or at least 10 times the doping concentration in the first subregions. Adjustment of the doping profiles provides the opportunity to improve the plasma distribution below the termination region and maintain or improve (termination limited) diode turnoff SOA.

According to a further embodiment, the second subregions extend into the edge region. The edge region may consist of the parts of the second subregions extending into the edge region and the bigger part of the edge region described above. The first subregions may end before the edge region, i.e. do not extend into the edge region. For example, the first subregions adjoin the edge region.

According to a further embodiment, the pilot region is laterally surrounded by the mixed region, e.g. completely laterally surrounded by the mixed region. For example, the pilot region is spaced from the edge region by the mixed region.

According to a further embodiment, the pilot region, i.e. the shape of the pilot region, has a rotational symmetry with respect to a symmetry axis. The symmetry axis may run obliquely, e.g. perpendicularly, to the collector layer and/or through the collector layer. Obliquely or perpendicularly to the collector layer means, e.g., obliquely or perpendicularly to a main extension plane of the collector layer. The symmetry axis may run through the pilot region.

For example, the pilot region has a 2-fold or 3-fold or 4-fold rotational symmetry or a circular symmetry with respect to the symmetry axis. In top view of the collector side, the pilot region may have the shape of a circle or a cross or a star or a rectangle.

According to a further embodiment, the arrangement of the first subregions and the second subregions in the mixed region has a rotational symmetry with respect to the symmetry axis. For example, the rotational symmetry is 2-fold or 3-fold or 4-fold or is a circular symmetry.

According to a further embodiment, the pilot region has at least two arms extending from a center of the pilot region in radial direction. For example, the pilot region has at least three or at least four such arms. The center of the pilot region may coincide with a center of the collector side.

Radial directions are herein understood to be lateral directions running through and pointing towards or away from the center of the pilot region.

At the collector side, the first and second subregions may all run parallel to a radial direction. For example, the first and second subregions are each formed strip-like. The widths of the first and/or second subregions may each be smaller than the width of the edge region and/or of the pilot region. For example, the width of each of the first and/or second subregions is at most 50 % or at most 10 % or at most 1 % of the width of the edge region and/or the pilot region.

According to a further embodiment, the pilot region is connected to one or more first and/or second subregions. This means that the pilot region directly adjoins one or more first subregions and/or one or more second subregions.

According to a further embodiment, the total area of the pilot region is at least 10 % or at least 20 % of the total area of the mixed region. Additionally or alternatively, the total area of the pilot region may be at most 60 % or at most 45 % or at most 35 % of the total area of the mixed region.

According to a further embodiment, the pilot region is a contiguous region, e.g. a simply-connected region.

According to a further embodiment, the semiconductor body further comprises a base layer. The base layer may be of the second conductivity type. For example, the base layer is n-doped. The doping concentration in the base layer may be smaller than in the second subregions.

According to a further embodiment, the semiconductor body comprises at least one well region. For example, the semiconductor body comprises several, e.g. at least ten or at least 100, well regions. All features disclosed in connection with one well region are also disclosed for the other well regions. For example, the well region is of the first conductivity type. For example, the well region is p-doped. The doping concentration of the well region may be smaller than, equal to or larger than that of the pilot region and/or of the first subregions.

The well region may be spaced from the collector layer by the base layer. In other words, the base layer may be arranged between the well region and the collector layer. For example, there is no direct connection between the well region and the collector layer.

According to a further embodiment, the semiconductor body further comprises at least one emitter region. The semiconductor body may comprise a plurality of emitter regions, e.g. at least ten or at least 100 emitter regions. All features disclosed for one emitter region are also disclosed for the other emitter regions.

The emitter region may be of the second conductivity type. For example, each well region is assigned at least one emitter region. The emitter region may be embedded in the well region. The emitter region may be spaced from the base layer by the well region, i.e. there is no direct contact between the base layer and the emitter region. The doping concentration in the emitter region may be smaller than, equal to or greater than the doping concentration in the second subregions. For example, the doping concentration in the emitter region is greater than in the base layer.

The well region and/or the emitter region may adjoin the emitter side of the semiconductor body.

According to a further embodiment, at least one emitter electrode is arranged on the emitter side. The emitter electrode may comprise or consist of metal. The emitter electrode may be in electrical contact to at least one emitter region. The RC-IGBT may comprise several emitter electrodes. All features disclosed in connection with one emitter electrode are also disclosed for the other emitter electrodes. For example, each emitter region is assigned one individual emitter electrode. The emitter electrode may adjoin the assigned emitter region at the emitter side.

According to a further embodiment, at least one gate electrode is arranged on the emitter side. The gate electrode may be electrically insulated from the at least one well region and/or the at least one emitter region. The gate electrode is, e.g., arranged above the well region but laterally offset from the emitter region. For example, the gate electrode is electrically insulated from the semiconductor body or any electrically conducting region of the semiconductor body. The RC-IGBT may comprise several gate electrodes. All features disclosed in connection with one gate electrode are also disclosed for the other gate electrodes. For example, each well region is assigned one individual gate electrode. The gate electrode may comprise or consist of at least one of: metal, heavily doped polysilicon.

In lateral direction, the edge region and/or the terminal region of the RC-IGBT may not overlap with any gate electrode or any emitter electrode or any well region or any emitter region.

According to a further embodiment, the width of the pilot region is at least as large as the thickness of the base layer or at least 2-times or at least 3-times the thickness of the base layer. The width of the first and/or second subregions may be smaller than the thickness of the base layer or at most 2-times the base layer thickness. The total width of the mixed region may be at least 2-times the base layer thickness.

Next, the method for producing an RC-IGBT is specified. The method is, in particular, suited for producing the RC-IGBT according any one of the embodiments described herein. Therefore, all features described in connection with the RC-IGBT are also disclosed for the method and vice versa.

According to an embodiment of the method, a semiconductor body with an emitter side and a collector side is provided. The semiconductor body comprises a collector layer with at least one pilot region of a first conductivity type and with a mixed region having first subregions of the first conductivity type and second subregions of a second conductivity type. The first subregions and the pilot region may have the same doping concentration. Then, the doping concentration in the pilot region and/or the first subregions is changed until the doping concentrations in the pilot region and the first subregions are different.

For changing the doping concentration, the pilot region may be masked and an additional implantation process may be performed, in which the doping concentration in the first subregions is increased while, due to the masking, the doping concentration in the pilot region does not change or changes less. This creates a lower doping concentration of the pilot region than in the first subregions of the mixed region and improves the RBSOA performance. Additionally or alternatively, for changing the doping concentration, a localized activation process may be performed, in which the first subregions are annealed while the pilot region is not.

To improve the Diode (3th quadrant) performance, the doping concentration of the pilot region can be made higher than of the first subregions. For increasing the doping concentration of the pilot region, the first subregions may be masked and an additional implantation process may be performed in which the doping concentration in the pilot region is increased while, due to the masking, the doping concentration in the first subregions does not change or changes less. Additionally or alternatively, for changing the doping concentration, a localized activation process may be performed, in which the pilot region is annealed while the first subregion is not.

Hereinafter, the RC-IGBT and the method for producing an RC-IGBT will be explained in more detail with reference to drawings on the basis of exemplary embodiments. The accompanying figures are included to provide a further understanding. In the figures, elements of the same structure and/or functionality may be referenced by the same reference signs. It is to be understood that the embodiments shown in the figures are illustrative representations and are not necessarily drawn to scale. In so far as elements or components correspond to one another in terms of their function in different figures, the description thereof is not repeated for each of the following figures. For the sake of clarity, elements might not appear with corresponding reference symbols in all figures.
Figure 1 shows a first exemplary embodiment of the RC-IGBT in top view of the collector side,
Figure 2 shows a second exemplary embodiment of the RC-IGBT in a cross-sectional view,
Figure 3 shows a section of figure 2 in more detail,
Figure 4 shows the second exemplary embodiment of the RC-IGBT in top view of the collector side,
Figures 5 and 6 show further exemplary embodiments of the RC-IGBT each in top view of the collector side,
Figures 7 and 8 show measurement results,
Figure 9 shows a flow chart of an exemplary embodiment of the method for producing an RC-IGBT.

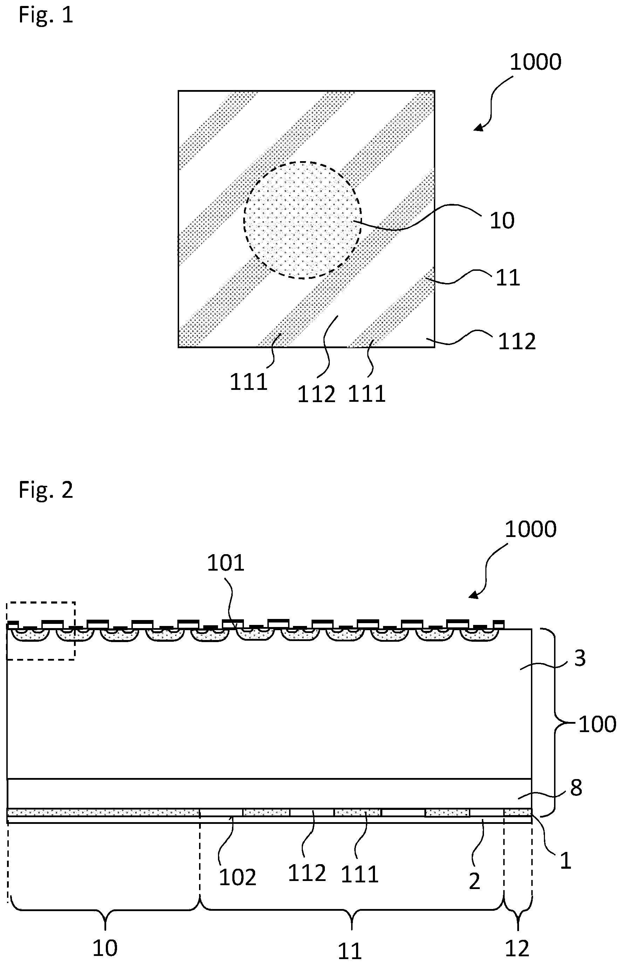

Figure 1 shows a first exemplary embodiment of the RC-IGBT 1000 in top view of the collector side. The RC-IGBT 1000 comprises a semiconductor body with an emitter side and a collector side and a collector layer at the collector side.

The collector layer forming the collector side comprises a pilot region 10 and a mixed region 11 (for illustration separated by the dashed line). The pilot region 10 is of a first conductivity type. The mixed region comprises first subregions 11 which are also of the first conductivity type and second subregions 112 which are of a second conductivity type. For example, the pilot region 10 and the first subregions 111 are p-doped and the second subregions 112 are n-doped.

As indicated by the different structuring of the different regions/subregions, a doping concentration in the pilot region 10 is different from a doping concentration in the first subregions 111. For example, the doping concentration in the pilot region 10 is smaller than in the first subregions 111.

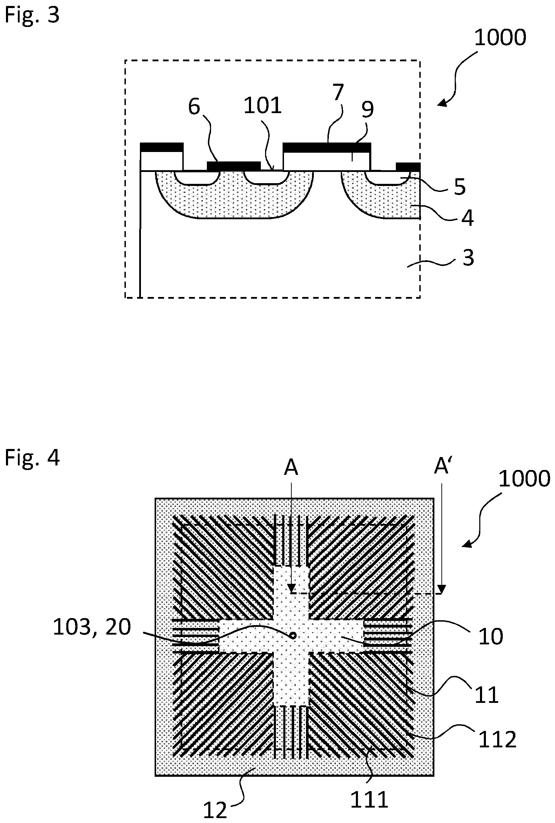

Figures 2 to 4 show a second exemplary embodiment of the RC-IGBT 1000. Thereby, figure 2 is a view on the cross-sectional plane AA' of figure 4. Figure 4 shows the RC-IGBT 1000 in top view of the collector side of the RC-IGBT. Figure 3 shows the framed section of figure 2 in greater detail.

The RC-IGBT 1000 comprises a semiconductor body 100 with a base layer 3, a buffer layer 8, and a collector layer 1. The buffer layer 8 and the base layer 3 may be of a second conductivity type. In this exemplary embodiment, the first conductivity type is hole conduction and the second conductivity type is electron conduction. Hence the base layer 3 and the buffer layer 8 are both n-doped. However, they may have different doping concentrations. For example, the doping concentration in the buffer layer 8 is greater than in the base layer 3. The base layer 3 may be thicker than the buffer layer 8. Moreover, the base layer 3 and/or the buffer layer 8 may be thicker than the collector layer 1.

The collector layer 1 comprises a pilot region 10 and a mixed region 11. The mixed region 11 comprises a plurality of first subregions 111 and a plurality of second subregions 112. The first subregions 111 and the pilot region 10 are both of the first conductivity type but have different doping concentrations. Hence, in the present case, they are both p-doped. For example, the doping concentration in the pilot region 10 is smaller, e.g. by at least a factor of 2, than in the first subregions 111.

The second subregions 112 are of the second conductivity type, hence, in the present case, they are n-doped. The collector layer 1 forms a collector side 102 of the semiconductor body 100. The pilot region 10 and the subregions 111, 112 reach to the collector side 102, i.e. each forms a part of the collector side 102. A collector electrode 2 is arranged on top of the collector side 102 and is in electrical contact with the collector side 102. The collector electrode 2 is, e.g., of metal.

Moreover, the collector layer 1 comprises an edge region 12. The edge region 12 adjoins or forms a lateral edge of the collector layer 1. The edge region 12 may partially or completely overlap with the termination region of the RC-IGBT in lateral direction. For example, the edge region 12 is defined by the termination region.

The termination region is a region of the RC-IGBT laterally surrounding an active region of the RC-IGBT. The active region is the region in which the device conducts current during on-state.

At an emitter side 101, opposite the collector side 102, the semiconductor body 100 comprises a plurality of well regions 4 (for better illustration, see figure 3). The well regions 4 are, e.g., of the first conductivity type, i.e. p-doped. Embedded into the well regions 4 are emitter regions 5, which are, e.g., of the second conductivity type, i.e. n-doped. On top of the emitter side 101, emitter electrodes 6 are arranged which are in electrical contact to the emitter regions 5. Furthermore, gate electrodes 7 are arranged on the emitter side 101 and are insulated from the semiconductor body 100 by insulating material 9. The emitter electrodes 6 and the gate electrodes 7 are, e.g., formed of metal. The insulating material 9 may comprise or consist of SiO₂.

The termination region and/or the edge region 12 may be defined by the region at the lateral side of the RC-IGBT not overlapping with any emitter electrode 6 and/or any gate electrode 7 and/or any emitter region 5 and/or any well region 4 in lateral direction.

Looking now at figure 4, showing the second exemplary embodiment of the RC-IGBT 1000 in top view of the collector side 101, one can see that the pilot region 10 has the shape of a cross. A center 103 of the pilot region 10 coincides with the center of the collector side 102. The pilot region 10 has a 4-fold rotational symmetry with respect to a symmetry axis 20 running perpendicularly to the drawing plane and through the center 103.

As can also be seen in figure 4, the arrangement of the first subregions 111 and the second subregions 112 in the mixed region 11 also follows a 4-fold rotational symmetry with respect to the symmetry axis 20. The mixed region 11 laterally completely surrounds the pilot region 10. The mixed region 11 and the pilot region 10 are furthermore laterally completely surrounded by the edge region 12. The borders between the mixed region 11 and the pilot region 10 and between the mixed region 11 and the edge region 12 are in each case indicated by dashed lines.

In the exemplary embodiment of figure 4, the area of the pilot region 10 is greater than the area of each of the first 111 and/or the second 112 subregions, e.g. at least 5-times as large as the area of each of the first 111 and/or second 112 subregions. The area of the pilot region 10 is, e.g., between 10 % and 35 % of the area of the mixed region. A width of the pilot region 10 may be at least 2-times the thickness of the base layer 3.

The first 111 and the second 112 subregions are in each case formed strip-like. The width of each of the subregions 111, 112 may be smaller than the thickness of the base layer 3, e.g. at most 50 % of the thickness of the base layer 3.

The area of the edge region 12 may also be larger than the area of each of the first 111 and/or the second 112 subregions, e.g. at least 5 times as large.

In the exemplary embodiment of figures 2 to 4, the second subregions 112 extend into the edge region 12 and form part of the edge region 12. The rest of the edge region 12, namely the bigger part of the edge region 12, is of the same conductivity type as the pilot region 10 and the first subregions 111, namely of the first conductivity type.

In the present exemplary embodiment, the doping concentration of the bigger part of the edge region 12 is the same as in the first subregions 111. The doping concentration in the pilot region 10 is, however, smaller than in the first subregions 111 and the bigger part of the edge region 12.

The bigger part of the edge region 12 being of the first conductivity type forms a contiguous subregion of the edge region, which completely surrounds the mixed region 11 and the pilot region 10.

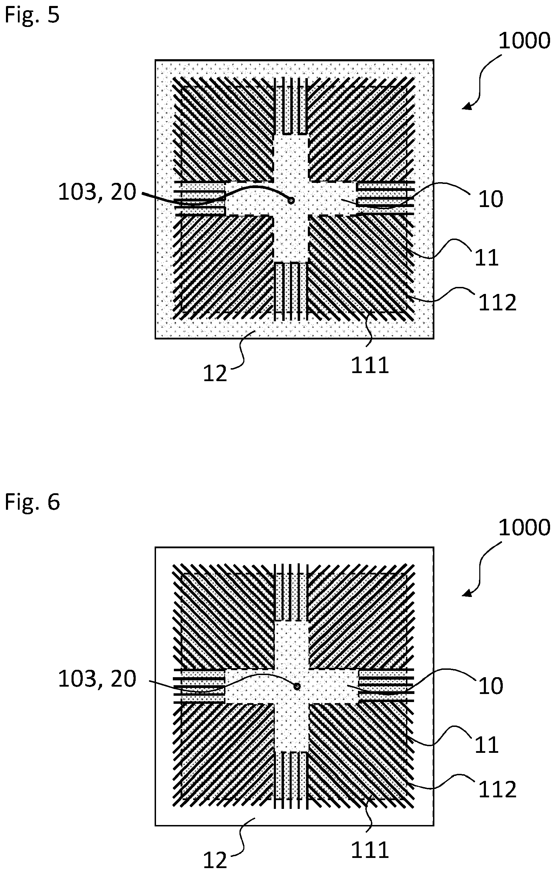

Figure 5 shows a further exemplary embodiment of the RC-IGBT 1000. A cross-section of this RC-IGBT 100 may look similar to the cross-section of figure 2. However, compared to the previous exemplary embodiment, the top view of the collector side looks different. In contrast to the previous exemplary embodiment, the bigger part of the edge region 12 does not have the same doping concentration as the first subregions 111, but has the same doping concentration as the pilot region 11.

In the exemplary embodiment of figure 6, again only the top view of the collector side is shown. Here, in contrast to the previous exemplary embodiments, the bigger part of the edge region 12 is not of the first conductivity type but of the second conductivity type. The bigger part of the edge region may thereby have a different doping concentration than the second subregions 112 of the mixed region 11.

All shown exemplary embodiments have in common that the doping concentration in the pilot region and the first subregions of the mixed region are different. In the described exemplary embodiments, the first conductivity type was hole conduction and the second conductivity type was electron conduction. However, this is only one example and also the opposite case, namely first conductivity type being electron conduction and second conductivity type being hole conduction, is possible.

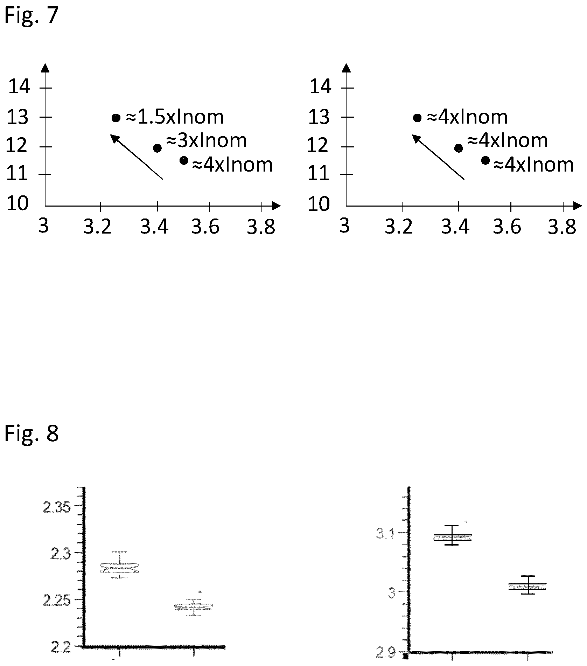

Figure 7 (left side) shows measured examples of the technology curve influence for increasing implantation dose (20% resp. 40%) (see arrow) when both, the first subregions and the pilot region, always have the same doping concentration. On the y-axis, the turnoff switching loss (i.e. energy dissipated during a switching event from the onsate to the off-state) is shown. On the x-axis, VCEsat (the voltage between emitter and collector when in saturation) is shown. As expected, the increase in implantation dose (increase in doping concentration) lowers VCEsat, while also showing a corresponding RBSOA reduction (in terms of maximum current turnoff capability, decreasing from 4x Inom to 1.5x Inom). For all three points, the RBSOA failure location has been observed above the pilot region. This indicates the pilot region as the weak point across all doping ranges. This particularly limits movement to the lower condition losses part of the technology curve, a region advantageous to the (low switching frequency) HVDC applications in which the BIGT is predominantly used. By tailoring the doping in the pilot region specifically for improved RBSOA and the mixed region for improved on-state, estimated SOA performance, improvements as indicated in figure 7 (right side) can be expected.

Experimental results of a lowered diode on-state both with (left figure) and without (right figure) BIGT MOS control are shown in figure 8. On the y-axis, the conduction losses in diode mode are indicated. In both figures, the left data point corresponds to the case where the edge region below the termination region has the same doping concentration and the same conductivity type as the first subregions (see figure 4). The lowered on-state for the right data points is due to the use of an edge region with a bigger part thereof being of a different conductivity type than the pilot region or the first subregions, respectively, e.g. n-doped. Here, as an example, the n-doping in the edge region is equal to that of the second subregions in the mixed region. Diode on-state improvements just like that of the IGBT on-state are once again a key for better system level performance in low frequency HVDC systems. Finally, the no MOS control on-state improvements also benefit systems in which BIGTs are used as a plug and play component for more general (no MOS control) system topologies.

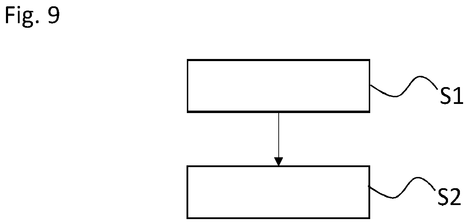

Figure 9 shows a flowchart of an exemplary embodiment of the method for producing an RC-IGBT. First, in a step S1, a semiconductor body with an emitter side and a collector side is provided. The semiconductor body comprises a collector layer with at least one pilot region of a first conductivity type and with a mixed region having first subregions of the first conductivity type and second subregions of a second conductivity type. The first subregions and the pilot region have the same doping concentration. Then, in a step S2, the doping concentration in the pilot region and/or the first subregions is changed until the doping concentrations in the pilot region and the first subregions are different.

The embodiments shown in the Figures 1 to 6 and 9 as stated represent exemplary embodiments of the improved RC-IGBT and the method; therefore, they do not constitute a complete list of all embodiments according to the improved RC-IGBT and the method. Actual RC-IGBTs and the actual method may vary from the embodiments shown in terms of arrangements, for example.

### Reference Signs

- 1: collector layer
- 2: collector electrode
- 3: base layer
- 4: well region
- 5: emitter region
- 6: emitter electrode
- 7: gate electrode
- 8: buffer layer
- 9: insulating material
- 10: pilot region
- 11: mixed region
- 12: edge region
- 20: symmetry axis
- 100: semiconductor body
- 101: emitter side
- 102: collector side
- 103: center
- 111: first subregion
- 112: second subregion
- 1000: Reverse-Conducting Insulated Gate Bipolar Transistor
- S1, S2: method steps

## Claims

1. A Reverse-Conducting Insulated Gate Bipolar Transistor (1000), comprising
- a semiconductor body (100) with an emitter side (101) and a collector side (102),
- a collector layer (1) at the collector side (102) with at least one pilot region (10) and at least one mixed region (11),
- a collector electrode (2) on the collector side (102) and in electrical contact with the collector layer (1), wherein
- the pilot region (10) is of a first conductivity type,
- the mixed region (11) has first subregions (111) of the first conductivity type and second subregions (112) of a second conductivity type,
- the doping concentration in the first subregions (111) is different from the doping concentration in the pilot region (10).

2. The Reverse-Conducting Insulated Gate Bipolar Transistor (1000) according to claim 1, wherein
- the doping concentration in the first subregions (111) is larger than the doping concentration in the pilot region (10) .

3. The Reverse-Conducting Insulated Gate Bipolar Transistor (1000) according to claim 1 or 2, wherein
- the collector layer (1) further comprises an edge region (12),
- the edge region (12) laterally surrounds the pilot region (10) and/or the mixed region (11),
- the bigger part of the edge region (12) is either of the first or the second conductivity type.

4. The Reverse-Conducting Insulated Gate Bipolar Transistor (1000) according to claim 3, wherein
- the bigger part of the edge region (12) is of the same conductivity type as the first subregions (111) and has the same doping concentration as the first subregions (111) .

5. The Reverse-Conducting Insulated Gate Bipolar Transistor (1000) according to claim 3, wherein
- the bigger part of the edge region (12) is of the same conductivity type as the first subregions (111) but has a different doping concentration than the first subregions (111) .

6. The Reverse-Conducting Insulated Gate Bipolar Transistor (1000) according to claim 3, wherein
- the bigger part of the edge region (12) is of the same conductivity type as the pilot region (10) and has the same doping concentration as the pilot region (10).

7. The Reverse-Conducting Insulated Gate Bipolar Transistor (1000) according to claim 3, wherein
- the bigger part of the edge region (12) is of the same conductivity type as the second subregions (112) but has a different doping concentration than the second subregions (112) .

8. The Reverse-Conducting Insulated Gate Bipolar Transistor (1000) according to any one of claims 3 to 7, wherein
- the second subregions (112) extend into the edge region (12) .

9. The Reverse-Conducting Insulated Gate Bipolar Transistor (1000) according to any one of the preceding claims, wherein
- the pilot region (10) is laterally surrounded by the mixed region (11).

10. The Reverse-Conducting Insulated Gate Bipolar Transistor (1000) according to any one of the preceding claims, wherein
- the pilot region (10) has a rotational symmetry with respect to a symmetry axis (20) running obliquely to and through the collector layer (1) and
- the arrangement of the first subregions (111) and the second subregions (112) in the mixed region (11) has a rotational symmetry with respect to the symmetry axis (20) .

11. The Reverse-Conducting Insulated Gate Bipolar Transistor (1000) according to any one of the preceding claims, wherein
- the pilot region (10) has at least two arms (101) extending from a center (103) of the pilot region (10) in radial directions.

12. The Reverse-Conducting Insulated Gate Bipolar Transistor (1000) according to any one of the preceding claims, wherein
- the pilot region (10) is connected to one or more first subregions (111),
- the total area of the pilot region (10) is at least 10 % of the total area of the mixed region (11),
- the pilot region (10) is a contiguous or simply-connected region.

13. The Reverse-Conducting Insulated Gate Bipolar Transistor (1000) according to any one of the preceding claims, wherein
- the semiconductor body (100) further comprises
- a base layer (3) of the second conductivity type,
- at least one well region (4) of the first conductivity type being spaced from the collector layer (1) by the base layer (3),
- at least one emitter region (5) of the second conductivity type being spaced from the base layer (3) by the well region (4),
- at least one emitter electrode (6) is arranged on the emitter side (101) and is in electrical contact to at least one emitter region (5),
- at least one gate electrode (7) is arranged on the emitter side (101) and is electrically insulated from the well region (4).

14. A method for producing a Reverse-Conducting Insulated Gate Bipolar Transistor (1000) comprising
- providing a semiconductor body (1) with an emitter side (101) and a collector side (102), wherein semiconductor body (1) comprises a collector layer (1) with at least one pilot region (10) of a first conductivity type and with a mixed region (11) having first subregions (111) of the first conductivity type and second subregions (112) of a second conductivity type, wherein the first subregions (111) and the pilot region (10) have the same doping concentration,
- changing the doping concentration in the pilot region (10) and/or the first subregions (111) until the doping concentrations in the pilot region (10) and the first subregions (111) are different.

15. Method according to claim 14, wherein for changing the doping concentration
- either the pilot region (10) or the first subregions (111) are masked and an implantation process is performed in which the doping concentration in the first subregions (111) or the pilot region (10) is increased while, due to the masking, the doping concentration in the respective other one of the pilot region (10) and the first subregions (111) does not change or changes less, and/or
- a localized activation process is performed, in which either the first subregions (111) or the pilot region (10) is annealed while the respective other one of the pilot region (10) and the first subregions (111) is not.
